Europäisches Patentamt

European Patent Office

Office européen des brevets

(19)

(11) Publication number: **0 196 891**
**B1**

# EUROPEAN PATENT SPECIFICATION

(45) Date of publication of the patent specification:
29.11.89

(51) Int. Cl.⁴: **H 02 H 9/04, H 01 L 45/00**

(21) Application number: 86302325.5

(22) Date of filing: 27.03.86

(54) Circuit protection device.

(30) Priority: 29.03.85 GB 8508304
19.03.86 GB 8606758

(43) Date of publication of application:
08.10.86 Bulletin 86/41

(45) Publication of the grant of the patent:
29.11.89 Bulletin 89/48

(84) Designated Contracting States:
AT BE CH DE FR GB IT LI NL SE

(56) References cited:
US-A- 3 271 591
US-A- 3 343 034
US-A- 3 436 601
US-A- 3 530 441
US-A- 4 236 188

APPLIED PHYSICS LETTERS, vol. 19, no. 7, 1st October 1971, pages 221-223; R. PINTO et al.: "Electric field induced memory switching in thin films of the chalcogenide system Ge-As-Se"
JOURNAL OF APPLIED PHYSICS, vol. 51, no. 6, June 1980, pages 3289-3309, American Institute of Physics; D. ADLER et al.: "Threshold switching in chalcogenide-glass thin films"

(73) Proprietor: RAYCHEM LIMITED, Rolls House 7, Rolls Buildings Fetter Lane, London, EC4 1NL (GB)

(72) Inventor: Vinson, John Reginald, 72 Hailsfield Cricklade, Nr. Swindon Wiltshire (GB)
Inventor: Crofts, David, 'Lorien', Somerford Keynes, Cirencester Gloucestershire (GB)
Inventor: Moore, Anthony James, 'Summerton', 2 Berkeley Road, Cirencester Gloucestershire (GB)
Inventor: Porter, Christopher John, 16 Caraway Drive, Swindon Wiltshire (GB)

(74) Representative: Dlugosz, Anthony Charles et al, Raychem Limited Intellectual Property Law Department Faraday Road Dorcan, Swindon, Wiltshire (GB)

## Description

This invention relates to circuit protection devices, and especially to devices for protecting electrical circuits against voltage transients that are caused by an electromagnetic pulse, e.g. lightning, and also the transients that are caused by electrostatic discharge.

Electrostatic discharge and electromagnetic pulses can all induce very high currents and voltages on cables and structures such as aeroplanes and ships, which can penetrate the electrical systems and damage them, either causing hardware damage such as semiconductor burnout, or electronic upset, e.g. transmission loss or loss of stored data. As semiconductor technology advances, the energy needed to cause such damage becomes less.

Electrostatic discharges are extremely fast discharges from a capacitor such as a human body. These discharges, because they can be so local, present an extreme threat to the individual electronic component. The magnitude of the threat is illustrated by reference to IEC Technical Committee TC65, WG4 draft specification or the SAE-AE-4 proposed specification on ESD. In these documents the maximum threat is a double exponential pulse of rise time 5 nanoseconds with a 30 nanosecond fall time. The peak voltage is given as 15,000 volts with a current of 70 amps. The energy storage capacitance is given as 150 pico farads giving a maximum energy of 33 millijoules.

Induced electrical transients caused by lightning represent a threat to electrical/electronic equipment especially in aerospace vehicles. The characteristics of the induced pulses are best described in the SAE AE4L Committee Report AE4L-81-22. Test Wave Forms and Techniques for Assessing the Effects of Lightning-Induced Transients. This specification describes the idealised version of the lightning stroke waveform and of those which occur when equipment cables are excited by the EM environment produced. The specification specified a range of transients which may be produced during normal operation. The waveforms expected on each line depends on a number of factors but the two basic types are (waveform 3) with a frequency of between 1 and 10 MHz, a rise time of 45 nanoseconds and a peak current of 24 amps. The alternative wave form (Wave Form 4A) is a decaying exponential with a rise time of 100 nanoseconds and a width of 2 microseconds with a peak voltage of 300 volts and peak current of 60 amps.

The most severe threat to electrical and electronic equipment is the electromagnetic pulse although all effects can generate large voltage or current spikes with very short rise times. The exact characteristics of the pulse are complicated although a typical pulse will exhibit a field strength of about $10^5$ Vm$^{-1}$ with an accompanying H field intensity of 130 Am$^{-1}$ (based on free space impedance of 377 ohms), a pulse width of a few microseconds and a rise time of a few nanoseconds. In general damaging amplitudes in the pulse occur within the frequency range of 10 KHz to 100 MHz.

In order to protect electrical circuits from such threats it would be desirable to incorporate therein a circuit protection device which, in normal operation, has a high resistance but which, when the circuit is subjected to a voltage surge, quickly changes to a low resistance state in order to short the current surge to earth, and, after the current surge has finished, immediately reverts to its high resistance state. Based on the electrical characteristics of the pulse and the nature of the equipment it is intended to protect, it is possible to determine what characteristics of a circuit protection device are necessary for it to be able successfully to protect the circuit against the pulse damage. For example, one set of guidelines published by H.R. Philipp and L.M. Levinson in H.Appl Phys 52(2) February 1981 pp. 1083 to 1090, the disclosure of which is incorporated herein by reference, specifies inter alia the following requirements for a surge arrestor material that is intended to short a voltage transient to earth:

| | |
|---|---|
| Threshold voltage | 100 V |
| Switching delay time | <1 nanosecond |
| Current capacity | up to 400 A |
| Insertion loss | <0.4 dB at 0 to 200 MHz |
| | <0.8 dB at 200 to 500 MHz |
| Size limit | 1 cm |

The insertion loss, or attenuation of an electrical signal, at any frequency may be determined from the capacitance of the device, and it is this value of attenuation which is required to determine the suitability of any protection device. Since the switching device will comprise a normally insulating switching element located between a pair of conductive electrodes, the capacitance of the device (assuming parallel plate configuration) is given by

$$C = \varepsilon_o \varepsilon_r . A . t^{-1}$$

where C is the capacitance; $\varepsilon_o$ is the absolute permitivity of free space (8.85 × 10$^{-12}$Fm$^{-2}$; $\varepsilon_r$ is the relative permitivity of the dielectric; A is the cross-sectional aera (in metres), and t is the thickness of the dielectric (in metres);
and the insertion loss, measured in decibels, is given by:

$$\text{Insertion loss} = 20.\log_{10}[V_1/V_2]$$

where $V_1/V_2$ is the ratio of the signal intensity without the device to that with the device, and is given by:

$$V_1/V_2 = [1 + (2\pi f C R)^2]^{1/2}$$

where f is the frequency of the signal (in Hertz); and R is the characteristic impedance.

In addition to these requirements, the device will need a resistance in normal operation of at least about $10^6$ ohms in order to allow the equipment to function correctly.

One class of material that has been proposed for use in the manufacture of circuit protection devices in general are the chalcogenide glasses, by which is meant glasses formed from elements of group VIB of the periodic table (IUPAC 1965 revision) together with other elements, especially those of groups IVB and VB, for example as described in U.S. Patent No. 3 271 591 and 3 343 034 to Ovshinsky. Certain of these glasses can be used fo form «threshold» devices by which is meant devices that will change from a high resistance state to a low resistance state on application of a high voltage (the lowest such voltage being referred to as the «threshold voltage») but which will remain in their low resistance state only for as long as a small «holding» current is maintained. Other chalcogenide glasses can be used to form «memory» devices which will change from a high resistance state to a low resistance state on application of a high voltage and which will remain in the low resistance state, even when no voltage is applied, until an approppriate, different, voltage pulse is applied. As will be appreciated, only threshold devices are appropriate for the production of circuit protection devices. US-A 3 983 076 describes other chalcogenide glasses which may form p-n type devices.

The chalcogenide glass materials have the advantage that they exhibit very short switching times between their high and low resistance states where the voltage transient that causes switching is significantly higher (e.g. about 50 V or more) than the threshold voltage, typically less than 1 nanosecond, which is sufficiently fast for protecting circuits from the transient. However, they suffer from a number of disadvantage that, hitherto, have prevented their use for such purposes. The shortcomings of such devices may be seen by comparing the properties of a typical glass with the properties required of a circuit protection device to meet the guidelines mentioned above (although it will be appreciated that other guidelines may require different properties). For example a typical chalcogenide glass material (for example $Te_{48}As_{30}Si_{12}Ge_{10}$ described in U.S. Patent No. 3 271 591) has the following properties:

| | | |
|---|---|---|
| Dielectric constant | | 10 |
| High resistance resistivity | $\varrho_{off}$ | $10^7$ ohm cm |
| low resistance resistivity | $\varrho_{on}$ | 0.07 ohm cm |
| threshold field strength $V_{th}$ | | $4\times10^5$ Vcm$^{-1}$ |

where the threshold field strength is the field strength across the device required to switch the glass to its low resistance (on resistance) state.

The minimum area needed for a device comes from a knowledge of the maximum current density that the materials can stand and the maximum current flow in a transient, and is given by:

$$\text{Minimum Area} = \frac{\text{EMP Current}}{\text{max. current density}}$$

The maximum current density is of the order of $2\times10^4$Acm$^{-2}$ (see D. Alder et al, J. Appl Phys Vol 51(6) 1980 P. 3289 to 3309) whilst the maximum current is, as mentioned above from Philipp and Levinson, up to 400 A.

Hence, for example, the device would need a cross-section of at least 2 mm$^2$ to exhibit the required current capacity of 400A given by the guidelines but for a required current capacity of 200 A, a minimum area of 1 mm$^2$ is needed. In practice, the smallest area that is compatible with the current density is preferred in order to minimise the capacitance of the device and hence the insertion loss. Also, since the threshold field strength of the glass is $4\times10^5$ Vcm$^{-1}$, the device would need a maximum thickness of 2.5 micrometres in order to exhibit a threshold voltage of 100 V. However, such a device would have a normal high resistance state resistance (off resistance) of $2.5\times10^5$ ohms which is far too low for normal operation of the equipment, and would also exhibit an insertion loss for frequencies up to 200 MHz of 6dB. If the thickness of the device were increased to give an acceptable insertion loss, the threshold voltage would be raised to 1000 V, while if the thickness were increased to give an acceptable off resistance the threshold voltage would be raised to 10000 V. Although it is possible to reduce the threshold field strength of the glass by appropriate choice of formulation, we have found that, in the previously proposed materials, other properties of the material are seriously impaired.

According to the present invention, there is provided a circuit protection device for protecting an electrical circuit which includes a threshold switching element (11, 28, 54, 75) formed from an amorphous composition characterised in that the composition comprises:

(a)   15 to 75 atomic % selenium;
(b)   10 to 65 atomic % arsenic; and
(c)   5 to 42 atomic % germanium or, if the composition contains less than 35 atomic % selenium, 5 to 35 atomic % germanium

in which the proportions of (a), (b) and (c) (based on the total molar quantity of (a), (b) and (c)) adds up to 100%.

We have found that it is possible to form threshold switches from such chalcogenide glasses that have a balance of properties that enable them to be used successfully for protecting equipment from voltage transients. For example, we have found that the threshold field strength of these glasses are, in general, lower than $4\times10^5$ Vcm$^{-1}$ and can be in the order of $1\times10^5$ Vcm$^{-1}$. Furthermore the off resistivity of the glasses can be in the order of $10^8$ ohm cm as compared with $10^7$ ohm cm for the previously proposed glasses. Thus it is possible to form circuit protection devices that are acceptable by appropriate choice of the glass optionally together with dimensional control of the device, for example by increasing the thickness of the chalcogenide glass switching element e.g. to 10 to 30 micrometres.

The threshold field strength of the element combined with the other properties thereof causes the threshold voltage of the device to remain at an acceptable value e.g. from 70 to 300 V, while the increased off resistivity of the element enables an acceptable normal resistance value of about $10^6$ ohms to be achieved. Indeed, the fact that these glasses act as threshold devices at all is contrary to previous references to these materials (R. Pinto J. Non-Crystalline Solids 6 (1971) 187–196, R. Pinto Thin Solid Films (1971) 391, J.P. deNeufville et al 5th International Conference on Amorphous and liquid semiconductors 1973 Vol 2 pp. 737–743 and U.S. Patent No. 3 530 441 to Ovshinsky) in which the glasses are described only as memory materials.

In addition, by the use of materials defined above it is possible to overcome one significant problem that has hitherto been largely ignored or has not been appreciated in connection with circuit protection: although such devices will often revert to their high resistance state as soon as the transient voltage has subsided, it is easily possible for a device to be forced permanently into low resistance state if the energy of the transient is large or if a number of rapid transients are experienced. In fact, the energy needed to «latch» the previously proposed devices permanently into their conductive state is relatively low and is often less than the expected energy of the transient against which the device is intended to provide protection. Thus, although the electrical and electronic equipment would be protected against the transient, the equipment would not then operate until the protection device is replaced or reset. In contrast, the materials used in the devices according to the present invention exhibit a relatively high energy to latch and often considerably higher than that exhibited by any of the previously proposed materials. The «energy to latch» or «latching energy» is defined herein as the electrical energy required to force the switching element or the glass composition permanently into low resistance state. Some values for the energy to latch are quoted herein in units of energy (mJ), and such values refer to glass compositions of 10 micrometre thickness and 1 mm² area. It is believed that the energy to latch is substantially proportional to the thickness of the glass, at least at thicknesses of this order of magnitude, and independent of the area, at least for areas of this order of magnitude, and so other values herein may be quoted in units of energy per thickness of the glass. Preferably the materials have an energy to latch of at least 2000, more preferably at least 5000 and especially at least 10,000 $Jm^{-1}$ (or, more correctly, microjoules micrometre$^{-1}$). The energy to latch should be determined using electrical energy of 1 MHz frequency.

The particular value desired for any property of the material used in the device according to the invention will depend, at least to some extent on the other properties of the material, and the choice of material may often represent a compromise between conflicting properties. We have found, however, that it is possible to define a property of the material, called herein the «figure of merit» which distinguishes those materials that may be used to form useful circuit protection devices from those that cannot be used. In some cases the figure of merit may be used alone to determine the suitability of a material although in many cases, depending on the expected threat to the equipment, the figure of merit should be used together with one or more other criteria. The figure of merit for the glass compositions is defined herein as follows:

$$\text{Figure of merit} = \frac{E_L \cdot \rho_{off}}{V_{th} \cdot \varepsilon_r}$$

where $E_L$ is the energy required to latch the material in its low resistance state (measured in Joules per metre (of thickness) or microjoules per micrometre);
$\rho_{off}$ is the resistivity of the material in its high resistance state (measured in ohm metres);
$V_{th}$ is the threshold field strength of the material (measured in volts per metre); and
$\varepsilon_r$ is the dielectric constant of the material).

The materials used in the devices according to the present invention generally have a figure of merit of at least 5 units whereas those proposed in the prior art generally have a figure of merit below 0.3 and often below 0.1 unit. Preferably the material exhibits a figure of merit of at least 10, and more preferably at least 20 units (a unit being 1 $kgm^3s^{-2}A^{-1}$).

Alternatively or in addition, a figure of merit for the circuit protection device, rather than for the glass, may be defined as follows:

$$\text{Figure of merit} = \frac{E_L' \cdot R}{V' \cdot C}$$

where $E_L'$ is the energy to latch of the switching element (measured in joules);
R is the high resistance state resistance of the switching element (measured in ohms);
V' is the threshold voltage of the switching element (measured in volts); and
C is the capacitance of the switching element (measured in farads).

The device preferably has a figure of merit of at least $5 \times 10^{12}$, more preferably at least $1 \times 10^{13}$ and especially at least $2 \times 10^{13}$ $JA^{-1}F^{-1}$.

Preferably the composition contains not more than 35 atomic % germanium, more preferably not more than 30 atomic % germanium and especially not more than 25 atomic % germanium. Also, the composition preferably contains at least 20 atomic % selenium and especially at least 30 atomic % selenium but preferably not more than 70 atomic % selenium and especially not more than 60 atomic % selenium. The composition preferably contains at least 20 atomic % arsenic and especially at least 25 atomic % arsenic, but preferably not more than 60 atomic % arsenic and especially not more than 55 atomic % arsenic. Thus the composition preferably comprises:

(a)    20 to 70 atomic % selenium;
(b)    20 to 60 atomic % arsenic, and
(c)     5 to 30 atomic % germanium

and most preferably comprises:

(a)    30 to 60 atomic % selenium;
(b)    25 to 55 atomic % arsenic; and
(c)     5 to 25 atomic % germanium.

All the proportions of the components (a), (b) and (c) are based on the total molar quantity of (a), (b) and (c) alone and total 100%.

It is possible for quantities e.g. up to 10% or sometimes more, of other materials to be present in the compositions used in the devices according to the invention, for example minor amounts of the elements antimony, bismuth, silicon, tin, lead, halogens and some transition metals provided that the presence of such materials does not deleteriously affect the properties, such as the energy to latch and/or off resistivity, to a significant degree. It is preferred, however, for the compositions to contain substantially no tellurium since the presence of tellurium has been found to reduce the off resistivity of the materials severely, although, in certain circumstances, small quantities of tellurium may be tolerated, e.g. up to 10 atomic %, but preferably less than 5 atomic %.

The switching element is usually formed by a vapour deposition method in which a vapour of the appropriate composition is desposited onto one of the electrodes. The vapour may be generated by heating an appropriate mixture of the components (not necessarily having the same composition as the intended glass) or the separate components may simultaneously be heated.

Without wishing to be bound to any particular theory, it is currently believed that one factor in determining the quality of the switch is the contact resistance between the chalcogenide glass material and the electrodes, and that a reduction in the contact resistance can increase the energy to latch of the switch. Although many glass compositions falling within the range quoted above exhibit threshold characteristics irrespective of the electrode contact resistance, it appears that in some cases, and especially at the edges of the three component composition defined above, the improvement in the energy to latch caused by a substantial reduction in electrode contact resistance may even effectively cause a composition to change from one that exhibits memory characteristics to one that exhibits threshold caracteristics, and it is accordingly conjectured that the memory characteristics previously observed by Pinto and Ovshinsky et al could, in fact, be caused by a high electrode contact resistance. Thus, according to a further aspect, the invention provides a circuit protection device for protecting an electrical circuit from a voltage transient, which comprises a threshold switching element that is formed from an amorphous composition comprising germanium, selenium and arsenic, and a pair of electrodes in contact with the composition, the electrodes having a contact resistance with the composition that is sufficiently low to cause the device to exitibit an energy to latch of at least 40 mJ.

Preferably the electrode contact resistance is sufficiently low that the overall electrode-to-electrode resistance of the device is not more than 10 ohms and especially not more than 5 ohms, the most preferred resistance being less than 1 ohm. Low electrode contact resistance may be achieved for example by depositing the glass material on the electrode by a vacuum method for example by evaporation. If desired, materials such as indium may be provided as a layer between the electrode and the glass and/or incorporated in at least part of the glass in order to reduce the contact resistance.

The dimensions of the switching element used in the device according to the invention will depend on the particular chalcogenide glass composition that is used to form it, although the thickness of the switching element will usually be not more than 40 micrometres, preferably not more than 20 micrometres, but usually at least 5 and preferably at least 10 micrometres. The cross-sectional area of the switching element, in a plane normal to the direction of current flow therethrough, will depend on the maximum current flow. It is preferably at least 0.5 mm², the preferred size being about 1 mm² for discrete devices and for the maximum pulse level, at least 2 mm².

The devices may be incorporated in an electrical circuit in any suitable position, normally being connected between a current carrying line and earth, (the term «earth» in this context including any structure having an appropriate shape and/or capacity so that it can absorb the charge generated by the transient, and includes for example connection to the chassis and the like in vehicles such as aircraft), and, of course, more than one such device may be employed in the electrical circuit. The devices are conveniently incorporated in other electrical components for example electrical connectors, in which case the device will usually be connected between a current carrying element of the device and a terminal or other part of the device to be earthed e.g. a conductive housing.

Although in most instances the device will revert to its high resistance state as soon as the transient voltage has subsided, it is still possible for the device to be forced into a permanent low resistance state, for example if the voltage transient is unduly large or if a number of rapid transients are experienced. As mentioned above, whether or not the device will become permanently conductive depends on the amount of energy absorbed by the device from the transient. In some applications, for example in some ground installations, it may be desirable for the protection device to fail in this way, that is to say, so that the equipment is still protected against transients but will not function until the protection device is replaced or reset. In other applications it may be desirable for the device to fail in a high resistance (open circuit) state so that the equipment will carry on functioning although unprotected from subsequent transients. Thus in some cases the device may be connected in series to means that will exhibit a high resistance to the intended electrical circuit current at least when the switching element has become permanently conductive. Thus, for example, the switching element may be connected to the current carrying line or to earth via a fuse or switch that is capable of transmitting currents passed through it when the switching element is in its threshold mode but will change to a high resistance state when the switching device has become permanently conductive.

Alternatively or in addition, the device may include a capacitor to ensure that the device exhibits a high resistance to all frequencies below the cutoff limit of the capacitor. The use of a capacitor in series with the switching element has a number of advantages as mentioned in our copending British Patent Application entitled «Overvoltage protection Device: filed on even date herewith (Agent's reference no. RK269), the disclosure of which is incorporated herein by reference. Briefly, the use of a capacitor of appropriate size, for example from 10pF to 2 microfarads in series with the switching element will enable the transient current to be transmitted to earth, since most of the power of the transient current occurs at frequencies above 10 kHz, but will exhibit a high impedance to the intended currents in the circuit which will have significantly lower frequencies or will be a direct current. Also, the use of a capacitor will prevent or significantly reduce the possibility of the switching element latching in its low resistance state after a transient has occured. Such latching may occur in the absence of a capacitor due to current flow through the switching element keeping the switching element in its low resistance state. If a capacitor is used it is possible, in many cases, for only for a single capacitor to be employed in order to protect a number of lines if it is connected on the earth side of the switching elements, thereby allowing a greater degree of space saving.

Several embodiments of the invention will now be described by way of example with reference to the accompanying drawings, in which:

Figure 1 is a side view, partly in section, of a BNC coaxial connector that incorporates a circuit protection device according to the invention;

Figure 2 is a side view, partly in section, of a flat cable mass termination connector and wafers that incorporate a circuit protection device according to the invention;

Figure 3 is an enlarged view of part of the connector shown in figure 2;

Figure 4 is a perspective view of a modification of the wafers shown in figure 2;

Figure 5 is a schematic view of a capacitor that incorporates a circuit protection device according to the invention; and

Figure 6 is a diagram of a circuit used determine the energy to latch of the materials and devices according to the invention.

Figure 7 is a perspective view of a chip carrier employing the device according to the invention;

Figure 8 is a view, partly in section, of a modification of the chip carrier of figure 7;

Figure 9 is a section showing a further modification of the carrier shown in figure 7;

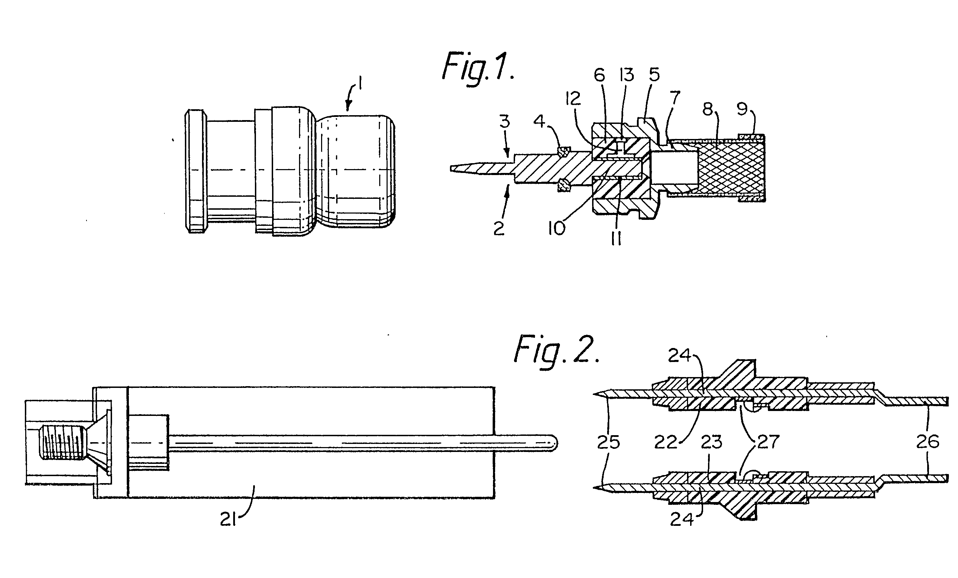

Referring to figure 1 of the accompanying drawings, a connection arrangement for connecting two coaxial cables comprises a connector shell 1 and a male connector 2. The male connector 2 comprises a pin 3, the central and rear portion of which is hollow for receiving the central conductor of a coaxial cable to be connected (not shown). The pin has a fluxed solder ring 4 and a number of apertures (not shown) beneath the solder ring which communcate between the solder ring 4 and the hollow interior of the pin 3. The rear end 10 of the pin is firmly located in a connector housing 5 by means of an electrically insulating plastics spacer 6. The housing 5, which provides the electrical connection between the shields of the cables to be connected, has a termination portion 7 on which is mounted a solder impregnated braid 8 and solder ring 9.

The rear end 10 of the pin is provided on its outer surface with an electrode, e.g. a molybdenum electrode followed by a 10 micrometre thick layer 11 of a selenium-germanium-arsenic glass described above that has been deposited thereon by a vapour deposition method, and the outer surface of the glass layer 11 has been provided with a further thin (about 5 micrometres thick) electrode, e.g. formed from molybdenum by a d.c. sputtering method. The molybdenum electrode is electrically connected to the housing 5 by means of a column or wire 12 or solder or other suitable conductive material.

In order to connect a coaxial cable to the connector, the outer jacket, shield and dielectric are cut back by appropriate amounts and the cable inserted into the connector so that the exposed end of the internal conductor is located within the hollow interior of the pin 3, the dielectric abuts the rear end of the spacer 6 and the exposed shield is located within the solder impregnated braid 8. The connector is then briefly heated, for example by means of a hot-air gun, to fuse the solder rings 4 and 9 and to form solder connections between the pin 3 and central conductor and between the braid 8 and coax cable shield.

The connector will function exactly as a standard coaxial connector until the connected cable experiences a voltage transient whereupon the potential difference across the thickness of the glass layer 11 will cause the glass to become electrically conductive and form a closed circuit between the central conductor and the shield.

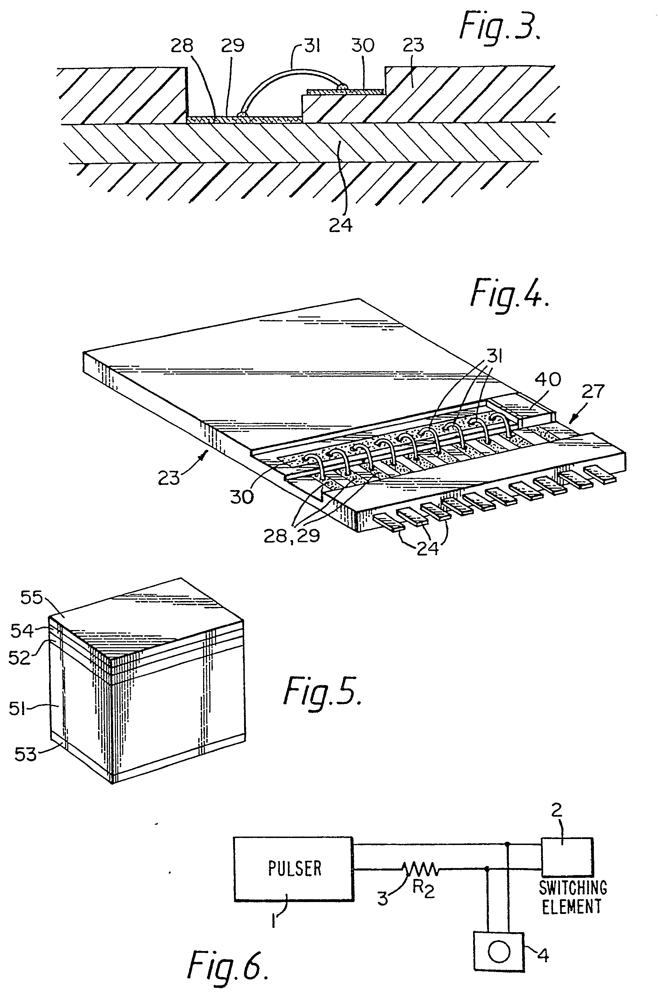

Referring to figures 2 and 3, a mass termination connector such as that described in British Patent No. 1 522 485 (the disclosure of which is incorporated herein by reference) is schematically shown.

The connector comprises a connector housing 21 and a pair of connector wafers 22 and 23 that can be inserted into the housing. Each wafer 22, 23 has a number of (usually 25 or 50) metallic electrical conductors 24 extending therethrough which terminate at one end either in the form of pins 25 or complementary «tuning fork» female contacts and at the other end in the form of contacts 26 for connection to a flat cable or to a number of small single conductor wires. The particular means used for connecting the conductors 24 to the wires or flat cable is not shown but usually comprises one or more solder devices for example as described in U.S. Patent Specification No. 3 852 517.

In each of the wafers 22 and 23 a stepped recess 27 is made that extends across the width of the entire wafer to expose each of the conductors. In one embodiment of this connector, a molybdenum electrode is deposited onto the individual conductors 24 followed by a 10 micrometre thick layer 28 of the selenium-germanium-arsenic glass described above, and a thin electrode 29 formed e.g. from molybdenum, gold or aluminium is deposited on top of the glass layer 28. An additional conductive layer 30 or«ground plane» of gold or aluminium is deposited on the wafer material in the stepped recess 27, the ground plane being electrically earthed for example to the metallic housing of the connector or to an earth pin. Each electrode 29 is connected to the ground plane by means of a wire 31 formed from e.g. gold or aluminium and bonded to the electrode 29 and ground plane 30 by conventional wire bonding techniques.

Alternatively, a single layer 28 of the glass and electrode 29 may be deposited accross the entire width of the wafer in which case only a single wire 31 is necessary for connection to the ground plane, or the ground plane and wire can even be dispensed with if one of the conductors 24 is earthed.

In an alternative construction, the selenium-germanium-arsenic glass layer and electrodes are deposited onto the common ground plane 30, and the wires 31 connect the conductors 24, after any appropriate surface preparation if necessary, with the electrode of the glass layer.

Figure 4 shows schematically a further modification of the wafer shown in figures 2 and 3. In this form of wafer the glass layers 28 and electrodes 29 are deposited on the conductors 24 as described above and are electrically connected to a ground plane 30 by means of wires 31. In addition, however, a 100 nanofarad capacitor 40 is located in the recess 27 and is connected between the ground plane and an earth terminal or housing of the connector. In this form of device any transient current having a frequency spectrum above about 1 MHz is conducted directly to earth while any direct currents or alternating currents of frequencies significantly lower than about 1 MHz are blocked by the capacitor. This modification of the device has the advantage that it reduces or eliminates the possibility of the glass switching layers 28 being held in their low resistance state by the direct currents in the electrical system after the transient has been transmitted to earth.

Figure 5 shows schematically a circuit protection device according to the invention that may be incorporated into any larger electrical component. The device comprises a capacitor 51 having a capacitance for example of 0.5 to 3 microfarads (although larger or smaller capacitances e.g. 0.1 to 1 microfarads may be desired in many circumstances) which is provided with terminals 52 and 53. A 10 micrometre thick layer 54 of the selenium-germanium-arsenic glass switching material described above is deposited on the terminal 52 for example by a vapour deposition method and then a thin electrode 55 for example formed from molybdenum is deposited on the glass layer 54 e.g. by a d.c. sputtering technique. Additional metal layers may be provided on top of the electrode 55 in order to improve the formation of solder joints if desired. As described above and in our copending Patent Application entitled «overvoltage protection device» filed on even date herewith (Agent's ref. RK269) the glass layer will become conductive when the circuit is exposed to a transient having a high frequency spectrum, e.g. above 1 MHz, to allow the transient to be passed to earth, but the capacitor will exhibit a high impendence to lower frequency signals and therefore prevent such signals latching the glass layer 54 in its low resistance state.

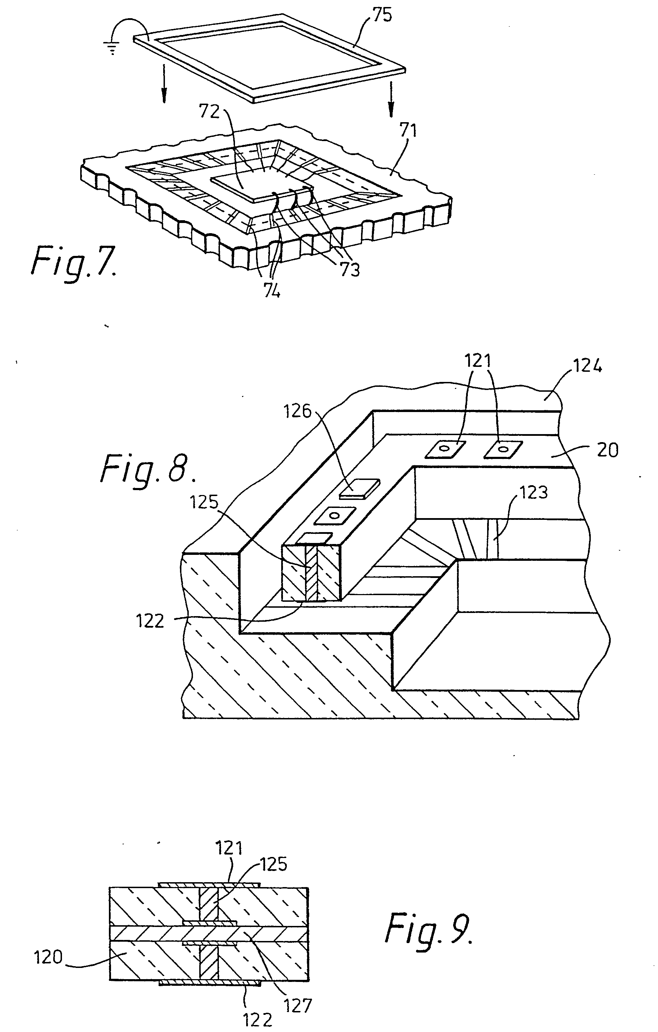

Figure 7 shows the use of a threshold circuit protection device according to the present invention on a chip carrier 71 containing a chip 72. The conductive I/O pads of chips 72 are wire bonded by wires 73 to conductive pads 74 in the chip carrier. The threshold circuit protection device 75 comprises a glass layer which contacts the conductive pads 74 of the chip carrier and an electrode layer in contact with the glass which can be grounded to earth through an appropriate earthpad in the chip carrier or any other appropriate point in the chip package. The threshold circuit protection device 75 covers a portion of the pad 74 of chip carrier 71 leaving a portion of each pad 74 available for wire bonding of the chip 72 and wires 73. The threshold circuit protection device 75 can be formed in situ on chip carrier 71 by first depositing the glass layer, for example by vapour deposition, on the appropriate areas of the conductive pads 74 of the chip carrier and then depositing the electrode layer on top of the glass, which in turn can be connected to earth through a separate wire bond to an earth pad or chip package frame. Alternatively the glass layer can be omitted from an appropriate pad on the chip carrier thereby permitting the electrode layer to be deposited on the glass and on and in contact with that pad which will serve as an earthing pad. The circuit protection device in the chip carrier allows all of the in/out circuits to be in contact with the glass layer which glass is in turn in contact with a ground plane. Thus any overvoltage which enters the package through any lead or I/O pad can immediately pass through the glass layer to the ground plane. As mentioned above, any appropriate elements such as the capacitor of figures 4 or 5 may also be built into the combination of the circuit protection device and the chip carrier. The circuit protection device 75 can be connected to pads 74 by conductive adhesive or other appropriate means.

Figure 8 shows a further modification of figure 7, here to frame 120 used to support the circuit protection device is multilayered. A pattern of electrodes 121, 122 is produced on both top an bottom faces of the frame to match electrodes 123 of the chip carrier 124. The two electrodes 121,122 on opposite faces are interconnected by a conducting channel or via 125. A circuit protection device 126 is built up on the top electrode pattern 121 of the frame 120 and when completed the frame can be fitted into the chip carrier as shown in figure 1. As shown in figure 9, it is also possible to incorporate within the frame material the elements of a capacitor 127 within the structure of the via 125. This system of assembly provides for a more robust package since the circuit protection device is separated from the electrode tracks of the chip carrier by the conducting vias.

The following Examples illustrate the invention:

Samples of a number of chalcogenide glass compositions were prepared by mixing the components, which were of at least 99,99% purity, and melting the mixture in a silica ampoule under a vacuum or under reduced argon pressure. During melting, which was carried out at temperatures of up to 1000°C and for periods of up to 48 hours depending on the composition, the ampoule was rocked and rotated in order to ensure that a homogeneous melt was obtained.

A 10 micrometre thick film of the glass so prepared was deposited onto a lower molybdenum electrode by vapour deposition at a pressure of $10^{-3}$ to $10^{-4}$ Pa using either a resistance heated, or an electron beam heated, source. Deposition rates of 0.3 to 1.0 micrometres per minute were employed. An upper molybdenum electrode of $1\,mm^2$ area was deposited by d.c. sputtering in argon at a pressure of 10 Pa and at a deposition rate of 20 to 30 micrometres per minute.

The glasses had the compositions shown in Table I.

Table I
Components (Parts by mole)

| Example | Si | Ge | As | Se | Te |
|---|---|---|---|---|---|
| 1. (Comparison) | 12 | 10 | 30 | | 48 |
| 2. (comparison) | | | 20 | 80 | |
| 3. (comparison) | | | 40 | 60 | |
| 4. | | 7 | 37 | 56 | |
| 5. | | 7 | 56 | 37 | |
| 6. | | 10 | 20 | 70 | |
| 7. | | 14 | 34 | 52 | |
| 8. | | 14 | 52 | 34 | |
| 9. | | 20 | 20 | 60 | |
| 10. | | 20 | 60 | 20 | |
| 11. | | 22 | 30 | 48 | |
| 12. | | 27 | 51 | 22 | |
| 13. | | 40 | 19 | 41 | |
| 14. (comparison) | | 14 | 34 | | 52 |
| 15. (comparison) | | 14 | 43 | | 43 |
| 16. (comparison) | | 14 | 34 | 26 | 26 |
| 17. (comparison) | | | 40 | 40 | 20 |
| 18. (comparison) | | | 40 | 20 | 40 |
| 19. | | 39 | 16 | 45 | |
| 20. | | 30 | 32 | 38 | |
| 21. | | 22 | 27 | 51 | |
| 22. | | 13 | 28 | 59 | |
| 23. | | 23 | 14 | 63 | |
| 24. | | 17 | 20 | 63 | |
| 25. (comparison) | | 55 | 32 | 13 | |

The electrical properties of the compositions are shown in Table II and of the devices formed from them are shown in Table III.

Table II

| Example | Energy to Latch (Jm$^{-1}$) | $\varrho_{off}$ (ohm m) | threshold field strength (MV$_m^{-1}$) | $\varepsilon_r$ | Figure of merit (kgm$^3$s$^{-2}$A$^{-1}$) |
|---|---|---|---|---|---|
| 1. (comparison) | 100 | $1\times10^5$ | 45 | 10 | 0.02 |
| 2. (comparison) | 2000 | $1\times10^6$ | 7.5 | 6.7 | 39 |
| 3. (comparison) | 2000 | $1\times10^6$ | 7.0 | 6.8 | 42 |
| 4. | 5000 | $3\times10^5$ | 10.0 | 7.0 | 22 |
| 5. | 7000 | $1\times10^6$ | 11.0 | 6.9 | 92 |
| 6. | 4000 | $1.5\times10^6$ | 9.0 | 6.8 | 98 |
| 7. | 15000 | $1.5\times10^6$ | 13.0 | 6.4 | 270 |
| 8. | 20000 | $6\times10^5$ | 14.0 | 6.6 | 130 |
| 9. | 5000 | $1\times10^6$ | 10.0 | 6.4 | 78 |
| 10. | 20000 | $1\times10^6$ | 16.0 | 6.7 | 186 |
| 11. | 30000 | $1\times10^6$ | 25.0 | 6.7 | 179 |
| 12. | 18000 | $1.2\times10^6$ | 16.0 | 6.8 | 198 |
| 13. | 5000 | $1\times10^6$ | 14.0 | 6.8 | 52 |
| 14. (comparison) | 3000 | $1\times10^4$ | 9.0 | 12.2 | 3.3 |
| 15. (comparison) | 6000 | $3\times10^3$ | 14.0 | 13.3 | 0.1 |
| 16. (comparison) | 6000 | $1\times10^4$ | 12.0 | 9.5 | 0.6 |
| 17. (comparison) | 2000 | $1\times10^5$ | 8.0 | 8.7 | 2.9 |

## Table II

| Example | Energy to Latch ($Jm^{-1}$) | $\varrho_{off}$ (ohm m) | threshold field strength ($MV_m{}^{-1}$) | $\varepsilon_r$ | Figure of merit ($kgm^3s^{-2}A^{-1}$) |
|---|---|---|---|---|---|
| 18. (comparison) | 50 | $5\times10^4$ | 10.0 | 9.7 | 0.3 |
| 19. | 4000 | $7\times10^5$ | 12.0 | 6.8 | 34 |
| 20. | 22000 | $2\times10^5$ | 10.0 | 6.8 | 65 |
| 21. | 16000 | $1.2\times10^6$ | 18.0 | 6.7 | 159 |
| 22. | 5000 | $1.0\times10^6$ | 12.0 | 6.5 | 64 |
| 23. | 4500 | $5\times10^5$ | 10.5 | 6.5 | 33 |
| 24. | 5000 | $1\times10^6$ | 11.0 | 6.8 | 67 |
| 25. | 2000 | $2\times10^5$ | 10.0 | 7.0 | 9 |

## Table III

| Example | Energy to Latch (mJ) | off resistance (M ohm) | Threshold Voltage (V) | Capacitance (pF) | Figure of Merit |
|---|---|---|---|---|---|
| 1. (comparison) | 1 | 1 | 450 | 8.8 | .25 |
| 2. (comparison) | 20 | 10 | 75 | 5.9 | 452 |
| 3. (comparison) | 20 | 10 | 70 | 6.0 | 476 |
| 4. | 50 | 3 | 100 | 6.2 | 242 |
| 5. | 70 | 10 | 110 | 6.1 | 1043 |
| 6. | 40 | 15 | 90 | 6.0 | 1111 |
| 7. | 150 | 15 | 130 | 5.6 | 3091 |
| 8. | 200 | 6 | 140 | 5.8 | 1478 |
| 9. | 50 | 10 | 100 | 5.6 | 893 |
| 10. | 200 | 10 | 160 | 5.9 | 2119 |
| 11. | 300 | 10 | 250 | 5.9 | 2034 |
| 12. | 180 | 12 | 160 | 6.0 | 2250 |
| 13. | 50 | 10 | 140 | 6.0 | 595 |
| 14. (comparison) | 30 | 0.1 | 90 | 10.7 | 3.1 |
| 15. (comparison) | 60 | 0.03 | 140 | 11.7 | 1.1 |
| 16. (comparison) | 60 | 0.1 | 120 | 8.4 | 6.0 |
| 17. (comparison) | 20 | 1 | 80 | 7.7 | 32.5 |
| 18. (comparison) | 5 | 0.5 | 100 | 8.5 | 2.9 |
| 19. | 40 | 7 | 120 | 6.0 | 388 |
| 20. | 220 | 2 | 100 | 6.0 | 733 |
| 21. | 160 | 12 | 180 | 5.9 | 1808 |
| 22. | 50 | 10 | 120 | 5.7 | 731 |
| 23. | 45 | 5 | 105 | 5.7 | 376 |
| 24. | 50 | 10 | 110 | 6.0 | 756 |
| 25. (comparison) | 20 | 3 | 100 | 6.2 | 97 |

The energy to latch of the device, and hence of the glass material, was measured by means of a circuit as shown in figure 6. Single shot pulses generated by means of a pulser 1 were passed to the switching element 2 connected in series with a current limiting resistor 3 having a resistance $R_2$ of from 40 to 100 ohms and the voltage across the switching element was observed by means of oscilloscope 4. The voltage generated by the pulser 1 was gradually increased (about 5 to 10 pulses being passed for each voltage level from the pulser) until the switching element latched in its low resistance state (determined by subsequently measuring its resistance).

The energy to latch te device, $E_L$ was determined by the equation:

$$E_L = J \cdot \frac{V^2}{(1000)} \cdot \frac{R_1}{(R_1+R_2)}$$

where J is the energy available from the pulser;

V ist the peak voltage from the pulser when latching occured;

$R_1$ is the internal output impedance of the pulser (5 ohms); and

$R_2$ is the resistance of the current limiting resistor.

This equation gives very good agreement with values obtained by integrating the current and voltage curves of the pulses.

Examples 26 to 28

A 10 micrometre thick layer of a $Ge_{14}As_{34}Se_{52}$ glass formed by the method of the previous Examples was provided with a number of electrodes of varying electrode contact resistance, and the energy to latch of the switch devices so formed was determined as described above.

In Example 26 a gold spring probe of 1 mm diameter was applied to the top surface of the glass layer with a force of 1g.wt., the opposite surface being provided with a copper film electrode.

In Example 27 copper electrode was provided on each surface of the glass layer by a vacuum evaporation method. However the electrodes were allowed partially to oxidize by readmission of air into the vacuum chamber while the electrodes were hot.

In Example 28 a 0.5 micrometre thick layer of the same glass composition but containing 15% indium was provided on each surface of the glass layer and 0.1 micrometre thick layer of indium was provided between each indium containing glass and (unoxidized) vacuum deposited copper electrodes. The results are shown in table IV.

Table IV

| Example | Threshold Voltage (V) | Energy to Latch (MJ) | Voltage across Electrodes (in low resistance state) (V) |
|---|---|---|---|
| 26. (comp) | 80 | < 5 | 20 |
| 27. (comp) | 110 | 25 | 20 |
| 28. | 110 | 200 | < 2 |

The resistance across the device was determined by replacing the device with standard resistances and comparing the voltage/time curve with that of the device when subjected to standard pulses. It was observed that the peak current flowing through the device was approxymately 1 ampere in all cases so that the resistance across the device (in ohms) is numerically equal to the voltage across the electrodes (in volts).

**Claims**

1. A circuit protection device for protecting an electrical circuit which includes a threshold switching element (11, 28, 54, 75) formed from an amorphous composition characterised in that the composition comprises:

(a)    15 to 75 atomic % selenium;
(b)    10 to 65 atomic % arsenic; and
(c)    5 to 42 atomic % germanium or, if the composition contains less than 35 atomic % selenium, 5 to 35 atomic % germanium

in which the proportions of (a), (b) and (c) (based on the total molar quantity of (a), (b) and (c)) adds up to 100%.

2. A device as claimed in claim 1, wherein the switching element is formed from a composition comprising:

(a)    20 to 70 atomic % selenium;
(b)    20 to 60 atomic % arsenic; and
(c)    5 to 30 atomic % germanium

in which the proportions of (a), (b) and (c) (based on the total molar quantitiy of (a), (b) and (c)) add up to 100%.

3. A device as claimed in claim 2, wherein the switching element is formed from a composition comprising:

(a)    30 to 60 atomic % selenium;
(b)    25 to 55 atomic % arsenic; and
(c)    5 to 30 atomic % germanium

in which the proportions of (a), (b) and (c) (based on the total molar quantity of (a), (b) and (c)) add up to 100%.

4. A device as claimed in claim 3, wherein the switching element is formed from a composition that comprises:

(a)    about 52 atomic % selenium;
(b)    about 34 atomic % arsenic; and
(c)    about 14 atomic % germanium

5. A device as claimed in any one of claims 1 to 4, wherein the switching element exhibits an energy to latch of at least 60mJ preferably at least 100 mJ.

6. A device as claimed in any one of claims 1 to 5, wherein the composition has an electrical resistivity in its high resistance state of al least $10^7$ ohm cm.

7. A device as claimed in any one of claims 1 to 6, wherein the composition has a figure of merit of at least 5 $kgm^3s^{-2}A^{-1}$.

8. A circuit protection device for protecting an electrical circuit from a voltage transient, which comprises an amorphous threshold switching element (11, 28, 54, 75) and a pair of electrodes (29, 52, 55) in contact with the composition, characterised in that the element is formed from a composition comprising germanium, selenium and arsenic and the electrodes have a contact resistance with the composition that is sufficiently low to cause the device to exibit an energy to latch of at least 40 mJ (for a 10 μm thickness).

9. A device as claimed in claim 8, which has an electrode-to-electrode resistance of not more than 1 ohm.

10. A device as claimed in claim 8 or claim 9, wherein the switching element (11, 28, 54, 75) has a composition comprising:

(a)    15 to 75 atomic % selenium;
(b)    10 to 65 atomic % arsenic; and
(c)    5 to 42 atomic % germanium; or if the composition contains less than 35 atomic % selenium, 5 to 35 atomic % germanium,

in which the proportions of (a), (b) and (c) (based on the total molar quantity of (a), (b) and (c)) add up to 100%.

11. A device as claimed in any one of claims 1 to 10, wherein the thickness of the switching element in the direction of current flow therethrough is less than 50 micrometres preferably not more than 25 micrometres.

12. A device as claimed in any one of claims 1 to 11, wherein the thickness of the switching element in the direction of current flow is at least 5 micrometres.

13. A device as claimed in any one of claims 1 to 12, wherein the cross-sectional area of the switching element in a plane normal to the direction of current flow therethrough is at least $0.5\,mm^2$.

14. A device as claimed in any one of claims 1 to 13, wherein the cross-sectional area of the switching element in a plane normal to the direction of current flow therethrough is not more than $2\,mm^2$.

15. A device as claimed in any one of claims 1 to 14, which includes means that will exhibit a high resistance if the switching element becomes permanently electrically conductive due to an excessive amount of energy put through the device.

16. An electrical circuit which includes a device as claimed in any one of claims 1 to 15 connected between a current carrying line of the circuit and earth.

17. An electrical component (2, 22, 23) which includes a current carrying element (3, 24), an element or terminal to be earthed (5, 27), and, electrically connected between the elements, a device as claimed in any one of claims 1 to 16.

18. An electrical component as claimed in claim 17 which is an electrical connector.

19. The use of an amorphous composition comprising:

(a)     15 to 75 atomic % selenium;
(b)     10 to 65 atomic % arsenic; and
(c)      5 to 42 atomic % germanium or, if the composition contains less than 35 atomic % germanium

in which the proportions of (a), (b) and (c) (based on the total molar quantity of (a), (b) and (c)) add up to 100%
as a threshold switching element (11, 28, 54, 75) for protecting an electrical circuit against voltage transients.

## Patentansprüche

1. Schaltungsschutzeinrichtung zum Schutz einer elektrischen Schaltung, die ein Schwellwertschaltelement (11, 28, 54, 75) enthält, das aus einer amorphen Zusammensetzung besteht, dadurch gekennzeichnet, daß die Zusammensetzung folgendes enthält:

(a)     15 bis 75 Atom-% Selen;
(b)     10 bis 65 Atom-% Arsen; und
(c)      5 bis 42 Atom-% Germanium; oder, wenn die Zusammensetzung weniger als 35 Atom-% Selen enthält, 5 bis 35 Atom-% Germanium,

wobei die Anteile von (a), (b) und (c), basierend auf der gesamten molaren Menge von (a), (b) und (c), sich zu 100% aufaddieren.

2. Einrichtung nach Anspruch 1, wobei das Schaltelement aus einer Zusammensetzung gebildet ist, die folgendes aufweist:

(a)     20 bis 70 Atom-% Selen;
(b)     20 bis 60 Atom-% Arsen; und
(c)      5 bis 30 Atom-% Germanium,

wobei die Anteile von (a), (b) und (c), basierend auf der gesamten molaren Menge von (a), (b) und (c), sich zu 100% aufaddieren.

3. Einrichtung nach Anspruch 2, wobei das Schaltelement aus einer Zusammensetzung gebildet ist, die folgendes aufweist:

(a)     30 bis 60 Atom-% Selen;
(b)     25 bis 55 Atom-% Arsen; und
(c)      5 bis 30 Atom-% Germanium,

wobei die Anteile von (a), (b) und (c), basierend auf der gesamten molaren Menge von (a), (b) und (c), sich zu 100% aufaddieren.

4. Einrichtung nach Anspruch 3, wobei das Schaltelement aus einer Zusammensetzung gebildet ist, die folgendes aufweist:

(a)     etwa 52 Atom-% Selen;
(b)     etwa 34 Atom-% Arsen; und
(c)      etwa 14 Atom-% Germanium.

5. Einrichtung nach einem der Ansprüche 1 bis 4, wobei das Schaltelement eine Energie zum Halten von mindestens 60 mJ, vorzugsweise von mindestens 100 mJ besitzt.

6. Einrichtung nach einem der Ansprüche 1 bis 5, wobei die Zusammensetzung einen spezifischen elektrischen Widerstand in seinem hohen Widerstandszustand von mindestens $10^7$ Ohm cm hat.

7. Einrichtung nach einem der Ansprüche 1 bis 6, wobei die Zusammensetzung eine Gütezahl von mindestens $5\,kgm^3s^{-2}A^{-1}$ hat.

8. Schaltungsschutzeinrichtung zum Schutz einer elektrischen Schaltung gegen eine momentane Überspannung, welche ein amorphes Schwellwertschaltelement (11, 28, 54, 75) und ein Paar von Elektroden (29, 52, 55) in Kontakt mit der Zusammensetzung aufweist, dadurch gekennzeichnet, daß das Element aus einer Zusammensetzung gebildet ist, die Germanium, Selen und Arsen enthält, und daß die Elektroden einen Kontaktwiderstand mit der Zusammensetzung haben, der ausreichend niedrig ist, damit die Einrichtung eine Energie zum Halten von mindestens 40 mJ (für eine Dicke von 10 μm) zeigt.

9. Einrichtung nach Anspruch 8, die einen Elektrode-zu-Elektrode-Widerstand von nicht mehr als 1 Ohm hat.

10. Einrichtung nach Anspruch 8 oder Anspruch 9, wobei das Schaltelement (11, 28, 54, 75) eine Zusammensetzung hat, die folgendes aufweist:

(a) 15 bis 75 Atom-% Selen;
(b) 10 bis 65 Atom-% Arsen; und
(c) 5 bis 42 Atom-% Germanium; oder, wenn die Zusammensetzung weniger als 35 Atom-% Selen enthält, 5 bis 35 Atom-% Germanium,

wobei die Anteile von (a), (b) und (c), basierend auf der gesamten molaren Menge von (a), (b) und (c), sich zu 100% aufaddieren.

11. Einrichtung nach einem der Ansprüche 1 bis 10, wobei die Dicke des Schaltelements in der Richtung des Stromflusses durch es hindurch weniger als 50 Mikrometer, vorzugsweise nicht mehr als 25 Mikrometer beträgt.

12. Einrichtung nach einem der Ansprüche 1 bis 11, wobei die Dicke des Schaltelements in der Richtung des Stromflusses mindestens 5 Mikrometer beträgt.

13. Einrichtung nach einem der Ansprüche 1 bis 12, wobei die Querschnittsfläche des Schaltelements in einer Ebene normal zur Richtung des hindurchgehenden Stromflusses mindestens $0,5 \, mm^2$ beträgt.

14. Einrichtung nach einem der Ansprüche 1 bis 13, wobei die Querschnittsfläche des Schaltelements in einer Ebene normal zur Richtung des hindurchgehenden Stromflusses nicht mehr als $2 \, mm^2$ beträgt.

15. Einrichtung nach einem der Ansprüche 1 bis 14, die eine Einrichtung enthält, welche einen hohen Widerstand zeigt, wenn das Schaltelement permanent elektrisch leitend wird aufgrund einer zu großen Energiemenge, die die Einrichtung durchströmt.

16. Elektrische Schaltung, die eine Einrichtung nach einem der Ansprüche 1 bis 15 enthält, welche zwischen eine stromführende Leitung der Schaltung und Erde geschaltet ist.

17. Elektrisches Bauteil (2, 22, 23), das ein stromführendes Element (3, 24), ein zu erdendes Element oder einen zu erdenden Anschluß (5, 27) und, elektrisch zwischen die Elemente geschaltet, eine Einrichtung nach einem der Ansprüche 1 bis 16 aufweist.

18. Elektrisches Bauteil nach Anspruch 17, welches ein elektrischer Verbinder ist.

19. Verwendung einer amorphen Zusammensetzung, umfassend:

(a) 15 bis 75 Atom-% Selen;
(b) 10 bis 65 Atom-% Arsen; und
(c) 5 bis 42 Atom-% Germanium; oder, wenn die Zusammensetzung weniger als 35 Atom-% Selen enthält, 5 bis 35 Atom-% Germanium,

wobei die Anteile von (a), (b) und (c), basierend auf der gesamten molaren Menge von (a), (b) und (c), sich zu 100% aufaddieren, als Schwellwertschaltelement (11, 28, 54, 75) zum Schutz einer elektrischen Schaltung gegen momentane Überspannungen.

**Revendications**

1. Dispositif de protection de circuit destiné à protéger un circuit électrique, qui comporte un élément de commutation à seuil (11, 28, 54, 75) formé à partir d'une composition amorphe, caractérisé en ce que la composition contient:

(a) 15 à 75 atomes pour cent de sélénium,
(b) 10 à 65 atomes pour cent d'arsenic, et
(c) 5 à 42 atomes pour cent de germanium ou, lorsque la composition contient moins de 35 atomes pour cent de sélénium, 5 à 35 atomes pour cent de germanium,

les proportions de (a), (b) et (c) (par rapport à la quantité molaire totale de (a), (b) et (c)) atteignant 100%.

2. Dispositif selon la revendication 1, dans lequel l'élément de commutation est formé à partir d'une composition contenant:

(a) 20 à 70 atomes pour cent de sélénium,
(b) 20 à 60 atomes pour cent d'arsenic, et
(c) 5 à 30 atomes pour cent de germanium,

les proportions de (a), (b) et (c) (par rapport à la quantité molaire totale de (a), (b) et (c)) atteignant 100%.

3. Dispositif selon la revendication 2, dans lequel l'élément de commutation est formé à partir d'une composition qui contient:

(a) 30 à 60 atomes pour cent de sélénium,
(b) 25 à 55 atomes pour cent d'arsenic, et
(c) 5 à 30 atomes pour cent de germanium,

les proportions de (a), (b) et (c) (par rapport à la quantité molaire totale de (a), (b) et (c)) atteignant 100%.

4. Dispositif selon la revendication 3, dans lequel l'élément de commutation est formé à partir d'une composition qui contient:

(a) environ 52 atomes pour cent de sélénium,
(b) environ 34 atomes pour cent d'arsenic, et
(c) environ 14 atomes pour cent de germanium.

5. Dispositif selon l'une quelconque des revendications 1 à 4, dans lequel l'élément de commutation présente une énergie de verrouillage d'au moins 60 mJ et de préférence d'au moins 100 mJ.

6. Dispositif selon l'une quelconque des revendications 1 à 5, dans lequel la composition a une résistivité électrique, à son état de résistance élevée, au moins égale à $10^7 \, \Omega.cm$.

7. Dispositif selon l'une quelconque des revendications 1 à 6, dans lequel la composition a un facteur de mérite au moins égal à $5 \, kg.m^3.s^{-2}A^{-1}$.

8. Dispositif de protection de circuit, destiné à protéger un circuit électronique contre une tension parasite, qui comporte un élément amorphe (11, 28, 54, 75) de commutation à seuil et deux électrodes (29, 52, 55) placées au contact de la composition, caractérisé en ce que l'élément est formé d'une composition de germanium, sélénium et arsenic, et les électrodes ont une résistance de contact avec la composition qui est suffisamment faible pour que le dispositif présente une énergie de verrouillage d'au moins 40 mJ (pour une épaisseur de 10 μm).

9. Dispositif selon la revendication 8, ayant une résistance entre électrodes qui ne dépasse pas 1 Ω.

10. Dispositif selon la revendication 8 ou 9, dans lequel l'élément de commutation (11, 28, 54, 75) a une composition contenant:

15 à 75 atomes pour cent de sélénium,
(a) 10 à 65 atomes pour cent d'arsenic, et
(b) 5 à 42 atomes pour cent de germanium ou,
·(c) lorsque la composition contient moins de 35 atomes pour cent de sélénium, 5 à 35 atomes pour cent de germanium,

les proportions de (a), (b) et (c) (d'après la quantité molaire totale de (a), (b) et (c)) atteignant 100%.

11. Dispositif selon l'une quelconque des revendications 1 à 10, dans lequel l'épaisseur de l'élément de commutation dans la direction de circulation du courant est inférieure à 50 μm et de préférence à 25 μm.

12. Dispositif selon l'une quelconque des revendications 1 à 11, dans lequel l'épaisseur de l'élément de commutation dans la direction de circulation du courant est d'au moins 5 μm.

13. Dispositif selon l'une quelconque des revendications 1 à 12, dans lequel la section de l'élément de commutation dans un plan perpendiculaire à la direction de circulation du courant est d'au moins 0,5 mm².

14. Dispositif selon l'une quelconque des revendications 1 à 13, dans lequel la section de l'élément de commutation dans un plan perpendiculaire à la direction de circulation du courant ne dépasse pas 2 mm².

15. Dispositif selon l'une quelconque des revendications 1 à 14, qui comporte un dispositif qui présente une résistance élevée lorsque l'élément de commutation devient conducteur électrique de façon permanente à la suite du passage d'une quantité excessive d'énergie dans le dispositif.

16. Circuit électrique qui comporte un dispositif selon l'une quelconque des revendications 1 à 15, connecté entre une ligne transmettant un courant et appartenant au circuit et la masse.

17. Composant électrique (2, 22, 23) qui comporte un élément (3, 24) de transport de courant, un élément ou une borne destiné à être relié à la masse (5, 27), et un dispositif selon l'une quelconque des revendications 1 à 16, relié électriquement entre les éléments.

18. Composant électrique selon la revendication 17, constituant un connecteur électrique.

19. Application d'une composition amorphe contenant:

(a) 15 à 75 atomes pour cent de sélénium,
(b) 10 à 65 atomes pour cent d'arsenic, et
(c) 5 à 42 atomes pour cent de germanium ou, lorsque la composition contient moins de 35 atomes pour cent de sélénium, 5 à 35 atomes pour cent de germanium,

les proportions de (a), (b) et (c) (d'après la quantité molaire totale de (a), (b) et (c)) atteignant 100%,
à un élément de commutation à seuil (11, 28, 54, 75) destiné à protéger un circuit électrique contre des tensions parasites).

Fig.1.

Fig.2.

EP 0 196 891 B1

Fig.3.

28  29  31  30  23

24

Fig.4.

31
40
27
23
30
28,29
24

55
54
52
51
53

Fig.5.

2

PULSER

3  R₂

SWITCHING
ELEMENT

I

4

Fig.6.

Fig.7.

Fig.8.

Fig.9.